Europäisches Patentamt

European Patent Office

Office européen des brevets

(11) Publication number: **0 283 608**
A1

## EUROPEAN PATENT APPLICATION

(21) Application number: 87302567.0

(22) Date of filing: 25.03.87

(51) Int. Cl.⁴ **D21H 5/18** , D21H 3/02 ,
H05K 1/03

(43) Date of publication of application:
28.09.88 Bulletin 88/39

(84) Designated Contracting States:
DE FR GB

(71) Applicant: **Corning Glass Works**
**Sullivan Park FR-212**
**Corning New York 14831(US)**

(72) Inventor: **Bartholomew, Roger Frank**
**8 Overbrook Road**
**Painted Post New York(US)**
Inventor: **Sawyer, Constance Bradley**
**371 Watson Creek Road**
**Lindley New York(US)**

(74) Representative: **Kyle, Diana et al**
**ELKINGTON AND FIFE High Holborn House**
**52/54 High Holborn**
**London WC1V 6SH(GB)**

(54) Laminated products from inorganic papers.

(57) Laminated board products such as electronic circuit boards are prepared from laminating-resin-impregnated inorganic papers formed of synthetic or naturally occurring micas, vermiculites, or other sheet silicate crystals which are substantially lithium-free. The presence of an octylamine conditioner during flocculation of the lithium-free silicate gel to a paper-making silicate slurry improves the compatibility of the inorganic paper with the laminating resin, improving board properties.

*Fig. 2*

## LAMINATED PRODUCTS FROM INORGANIC PAPERS

The present invention relates to resin-impregnated synthetic inorganic paper products composed primarily of natural or synthetic sheet silicate crystals, and particularly to laminated board formed of a plurality of such impregnated papers, which board is useful for applications such as printed circuit boards. A laminated board according to this invention may function as a substrate for a printed circuit assembly in which chip carriers and other components are mounted or printed on the substrate. The substrate may also be provided with conductive connections by subtractive or additive circuitry processes.

Considerable effort has been expended in developing papers based on inorganic materials. As reported by the Bureau of Mines in Bulletin 647(1969), entitled "Fluorine Micas", both natural and synthetic micas have been explored at considerable length. See particularly pages 214-242 of that bulletin.

The production of synthetic paper from vermiculite ore has been described in U.S. Patent No. 3,434,917. U.S. Patents Nos. 3,325,340 and 3,356,611 describe the preparation of vermiculite suspensions useful for the preparation of fibers or coatings.

Various inorganic papers have been produced commercially, but no large scale applications in electronic circuit boards have developed. Rather, papers and boards presently used for electrical purpose, e.g., component insulation, transformer wrapping and circuit substrates, are largely organics containing fiber fillers and/or fabric reinforcement. Where high temperature substrates are required, sintered ceramics such as alumina are commonly used.

U.S. Patent No. 4,239,519 discloses mica paper composed primarily of overlapping, ion-exchanged mica platelets prepared from a synthetic, lithium-and/or sodium-containing water-swelling mica wherein lithium and/or sodium ions from the mica have been partially exchanged for larger cations. The construction of circuit boards from such paper is described in published European patent application EPO115399.

In accordance with EPO115399, laminated mica circuit boards are made according to a procedure wherein the paper is first impregnated with an organic resin. The preferred resin is an epoxy which constitutes at least 15% by weight of the composite. Amounts of resin up to about 75% may be employed in special laminae, but a range of 20-50% is preferred. The paper is preferably composed of a synthetic lithium fluorhectorite mica wherein the lithium ions have been partially replaced by potassium ions; potassium-substituted fluorhectorites form a flocculated mass in aqueous media that can be processed into paper by conventional methods.

Board is made from the impregnated mica papers by stacking several layers of paper, and then applying heat and pressure to consolidate the papers into an integral, laminated body. A standard board thickness of 60 mils is typically formed with 10-15 sheets of paper, depending on paper thickness. The board is characterized by a low coefficient of thermal expansion which may be as low as $65 \times 10^{-7}/°C$ and is preferably 65 to $80 \times 10^{-7}/°C$.

Laminated boards made in accordance with EPO115399 are particularly suited for use in printed circuit assemblies. The board may have one or more ceramic chip carriers or other electrical components mounted on its surface. Further, it may have conducting circuitry applied by additive and/or subtractive techniques. Also, to provide reinforcement and/or to improve circuitry adhesion, the synthetic mica paper may on occasion be layered with glass fabric. Thin laminates of this type are sufficiently flexible that they may be employed as a flexible circuit substrate.

Natural micas have also been used to make laminated bodies; for a further discussion of the use of these naturally occurring materials to make paper laminates, reference may be made to E.G. Dingman, Society of Plastics Engineers Journal (September 1961), pp. 981-983. That publication describes mica papers made from reconstituted, or integrated, natural micas, and the use of such papers with resins in making laminates.

A particular advantage of circuit boards made according to EPO115399 from synthetic water-swelling micas arises from the thermal expansion characteristics of boards or substrates produced by laminating resin-impregnated papers composed of such crystals. The coefficients of thermal expansion in such laminates are isotropic in a planar sense, i.e., in the plane of the circuit board. That is to say, the coefficients along the X and Y axes are practically equal. This is in marked contrast to most laminated boards or substrates presently used in electrical equipment wherein coefficients along one planar axis tend to be greater than those along the other planar axis, sometimes almost twice as great.

A critical test of the suitability of a laminated board to be used for the construction of an electrical circuit is the ability of the laminate to stand up to the processing involved in adding the electrical circuitry. The application of conductive circuitry may involve subtractive or additive techniques such as chemical electrolytic deposition, electroless/catalytic deposition, printing, chemical etching, physical pressing, vacuum deposition or vacuum sputtering. The circuitry may be present on the board surface, plated or contained in board holes, or buried internally such as in a multilayered circuit board. The connection to the circuitry of discrete circuit elements or packaged integrated circuit components may involve high temperature flux application and wave soldering steps.

The chemical solutions and thermal cycling to which the laminated mica board is subjected during such processing puts a particularly high premium on the moisture resistance of the board material and the ability of the board material to resist delamination and/or microcracking which can provide exposed sites for moisture attack. Important factors affecting moisture resistance include not only the degree to which the paper is successfully impregnated with resins, but also the chemistry of the inorganic mica or other crystal used to form the paper.

The moisture resistance of a laminated product produced from inorganic crystals can be evaluated by exposure of the material to moisture at high temperatures, e.g., by immersion in boiling water. Preferably, laminated board products will exhibit little or no water absorption, and thus will not exhibit significant reductions in dielectric strength, loss tangent, and dielectric constant as a consequence of water attack.

Whereas the prior art teaches that laminated products may be composed of papers made from any suitable synthetic, water-swelling, lithium and/or sodium-containing mica crystals, the favored material in actual practice has been a synthetic lithium-containing water-swelling mica crystal because of the superior gel-forming characteristics of these crystals, their desirable high aspect ratio, excellent floc-forming characteristics in aqueous media, and acceptable electrical properties in laminated board form. Of course, efforts to further improve the electrical properties of these preferred lithium-containing materials has continued, and processing improvements such as the use of complex ion flocculation aids and treatment of the paper sheets after forming to enhance the moisture resistance thereof have resulted in substantial improvements in the ability of these laminated products to resist electrical deterioration in the presence of moisture.

Nevertheless, there remains a need for laminated board products of still better electrical properties than have been produced in the prior art. Thus it is a principal object of the present invention to provide a laminated product formed of an inorganic paper and a laminating resin which offers improved moisture resistance and electrical properties retention when exposed to high-humidity conditions.

It is a further object of the invention to provide improved paper-making procedures which can produce inorganic papers from sheet silicate crystals, whether natural or synthetic, exhibiting improved stability against hydration.

Other objects and advantages of the invention will become apparent from the following description thereof.

The present invention provides laminated board products made from synthetic or naturally occurring, water-swelled sheet silicate materials which are substantially lithium-free. These materials comprise aluminosilicate crystals of sheet-like morphology, but wherein the exchangeable interlayer cations are selected from among sodium, hydrogen, calcium and magnesium. These materials can be made synthetically, or they can be selected from among the available naturally occurring lithium-free sheet silicates.

Production of a laminated board product in accordance with the invention comprises the steps of first forming a gel containing lithium-free sodium, hydrogen, magnesium and/or calcium-containing sheet silicate crystals, flocculating the gel to cause the crystals to form a flocculated mass, forming and drying paper sheet from the flocculated mass, and impregnating the resulting paper with a suitable laminating resin such as an epoxy resin. The impregnated paper is then laminated and fused into a board product using heat and pressure. The resulting board is found to exhibit significantly improved moisture resistance and retention of electrical properties when compared with laminated lithium-containing board products of the prior art.

Conventional flocculation agents can be used to prepare the required paper sheet from sheet silicate gels such as above described, if desired. Preferably, however, flocculation is carried out in the presence of an ion-exchangeable conditioning agent which improves the susceptibility of the resulting paper to resin impregnation, and therefore improves the moisture resistance of the final product. More specifically, we have found that the use of an octylamine conditioning agent during the flocculation step provides a paper exhibiting substantially improved lamination properties. The octylamine conditioner is thought to undergo ion-exchange with sodium or other exchangeable ions present in the floc, resulting in a paper which is more compatible with organic laminating resins than standard paper and thus exhibits substantially improved lamination performance and water resistance when incorporated into laminated products.

The invention may be further understood by reference to the DRAWING, wherein:

Fig. 1 is an electron photomicrograph in polished cross-section of a laminated board product comprising paper produced by conventional flocculation, and

Fig. 2 is an electron photomicrograph in polished cross-section of a laminated board product comprising paper produced by the modified flocculation procedure of the invention.

In the prior art, as described for example in published European application EP0115399, a laminated board product can be prepared by preparing an inorganic paper composed of a lithium and/or sodium-containing, water-swelling mica material, impregnating the inorganic paper with an organic resin such as an epoxy resin, stacking the impregnated papers to form a board precursor, and finally laminating the precursor with heat and pressure to produce an integral board. While mixed sodium-lithium papers were used in the preparation of such board products, the preferred paper was a lithium fluorhectorite paper made in accordance with the procedures described in U.S. Patent No. 4,239,519.

Whereas the board products provided in accordance with that description exhibited good physical and electrical properties as made, exposure to moisture at high temperatures did cause some deterioration in electrical properties. Thus, for example, for board products containing lithium fluorhectorite paper and comprising epoxy laminating resins at loadings of 45-50% by weight, with target electrical properties including a dielectric constant of at least 4.5, a loss tangent (100 Hz) not exceeding about 0.030, water absorption not exceeding about 0.6% (wt.), and insulation resistance in excess of $10^8$ ohms, exposure of such products to boiling water for a 2-hour interval resulted in weight gains as high as 1.7% water, with loss tangent values in such instances increasing to as high as 2.4 or more and dielectric constants decreasing to as low as 2.9. Thus further improvements in resistance to electrical properties shifts upon exposure to moisture were desired.

The use of natural or synthetic lithium-free sheet silicate crystals can provide substantial improvements in the electrical performance of laminated board products subjected to moisture attack. Among the lithium-free materials which can be used for this purpose are sheet silicates selected from the group consisting of lithium-free vermiculites, sodium fluorhectorites, and sodium fluormontmorillionoids of appropriate crystal morphology. The latter sodium montmorillionoid materials, which are particularly preferred for laminated board manufacture, are produced by the controlled crystallization of sodium magnesium aluminosilicate glasses containing high analyzed levels of fluorine. Typical glass compositions suitable for the synthesis of crystallizable glasses for this purpose consist essentially of about 50-62% $SiO_2$, 20-28% $MgO$, 5-15% $Na_2O$, and 8-13% (analyzed) fluorine. These glasses and the preparation of paper-making gels therefrom form no part of the present invention, but are described and claimed in the copending patent application of G. H. Beall et al., "Sodium Fluormica Glass Ceramics", commonly assigned herewith.

Paper-making gels composed of vermiculite, a magnesium and aluminum-containing crystalline sheet silicate material, are known. The interlayer cations in vermiculite principally comprise hydrogen, calcium, magnesium, and/or sodium, with minor amounts of iron, nickel or the like also being present in the crystal composition. Such gels can be used for the preparation of laminated board products of improved moisture resistance as herein described provided that they are substantially lithium-free.

U.S. Patents Nos. 3,325,340, 3,356,611 and 3,434,917 describe vermiculite suspensions and the conversion thereof to paper. However, the preferred gels for making vermiculite paper are those described in the copending, commonly assigned patent application of H. L. Rittler, "Gels, Gel Products and Methods", Serial No. 742,954 filed June 10, 1985 and commonly assigned herewith. These are gels composed of vermiculite crystals which have been expanded by a primary aminocarboxy acid and dispersed in an aqueous solution (as hereinafter more fully described), a typical expanding agent being $\beta$-alanine.

Gels containing expanded vermiculite or sodium montmorillionoid may be used to prepare paper directly, but more preferably are supplemented with additions of glass fibers to improve the strength and integrity of the paper sheet. Such fiber additions will typically comprise 20-50% by weight of the solids content of the gel used to form paper.

To form paper sheet from gels such as described, flocculation of the gels is caused to occur with an added flocculant. Flocculation can be promoted via the addition to the gel of relatively large inorganic monovalent cations such as potassium, or other large organic cations or polycations may be used. The resulting floc, preferably comprising suitable glass fiber additions, can readily be formed into paper by hand sheet or continuous paper-making processes.

Procedures for making board products from inorganic gels have been standardized in the prior art and can readily be adapted to the manufacture of lithium-free board products. A suitable procedure comprises first preparing a gel of the selected lithium-free sheet silicate material, adding the gel to an aqueous dispersion of glass fibers in deionized water, and adding a flocculation agent to the mixture to cause flocculation of the sheet silicate crystals and the formation of a slurry. The resulting slurry can then be cast into a hand sheet mold, drained, and dried to form paper sheet.

To make laminated board from sheets of paper thus provided, the paper is generally first pretreated with a waterproofing agent, typically a water-soluble compound such as guanidine.HCL, to impart moisture resistance thereto. It is then impregnated with an epoxy resin containing suitable curing agents, precured (B-staged) prior to lamination, stacked in multiple layers to provide a board preform of the desired thickness, and finally laminated under heat and pressure to produce a cured board product. Using such standardized procedures, a comparison can readily be made of the electrical properties and resistance thereof to moisture deterioration as between conventional board products prepared from lithium fluorhectorite gels, and from sodium montmorillionoid gels provided according to the invention. Example I below outlines the results of such a comparison.

Example 1

Two gel samples of differing composition are formulated as starting materials for the preparation of inorganic paper sheet. The first gel, containing synthetic sodium fluoromontmorillionoid crystals, is produced by the dissolution in deionized water of a glass-ceramic sample consisting essentially, in weight percent, of 57.5% $SiO_2$, 25.0% MgO, 6.8% $Na_2O$, and 10.7% (analyzed) F. The other gel is formed by the dissolution of a lithium fluorhectorite glass-ceramic sample in water, the glass-ceramic being formed of a glass consisting essentially, in weight percent, of about 64.5% $SiO_2$, 17.3% MgO, 8.0% $Li_2O$ and 10.2% (analyzed) fluorine.

To prepare paper sheets from these silicate gels, the gels are combined with glass fibers in an aqueous medium adjusted to a pH of 2.5 with aqueous sulphuric acid. Combination is in proportions which will provide fiber-containing gels with solids contents of approximately 10% (wt.), wherein the solids consist of 20% glass fibers and the remaining 80% silicate crystals. Each of the two fiber-containing gels is then flocculated by the addition of a small quantity of a 0.2% polyethylene imine solution, the preferred polyethylene imine being commercially available as Epomin SP-012 flocculant from the Aceto Chemical Co., Flushing, N.Y. After flocculation has occurred the resulting slurries are poured into a hand sheet paper former, drained to form paper sheet, blotted dry and finally dried at 80°C on a chrome-plated dryer.

After the paper sheets have been prepared, they are pretreated in a 1.0M guanidine.HCL solution by immersing the paper in the solution for 30 minutes. This treatment reduces the susceptibility of the papers to hydration in the presence of ambient moisture. The guanidine-treated sheets are next washed repeatedly in clear deionized water and thoroughly dried at 110°C for at least 2 hours prior to further treatment.

Resin impregnation of paper sheets produced as described involves soaking the sheets in a varnish of epoxy resin for a time sufficient to achieve thorough penetration of the resin into the paper. An epoxy resin, commercially available as DER-566 from the Dow Chemical Company, is added to an acetone vehicle comprising 13.5 PHR (parts per hundred of resin) of diaminodiphenylsulfone (DDS) and 0.7 PHR of boron trifluoride monoethylamine ($BF_3$) as curing agents. The resin is added to the solvent in a quantity sufficient to provide a solids content of about 45% in the varnish. Other known laminating resins useful for fiberglass lamination, including phenolic, polyester, polyimide and polyetherimide resins, could alternatively be used.

Sheets of the above described lithium-and sodium-containing papers are immersed in this resin varnish for approximately 15 minutes, thereafter removed and air-dried for 10 minutes, and finally precured at 160°C for 4 minutes in a forced air oven. The precured papers are then vacuum dried overnight and stored in a dissicator until use.

To form laminated board products from the resin-treated papers thus provided, approximately 10 sheets of treated paper are stacked to form each laminated construction, opposing Teflon® fluorocarbon end sheets are applied to the opposing faces of the laminate, and the assembly is positioned in a Carver press for lamination. Each assembly is loaded into the press at room temperature and pressure is applied to 350 psi. The temperature is then increased at 10°C/min. to 125°C, the pressure is increased to 700 psi, and the temperature is further increased to 200°C, after which both temperature and pressure are maintained for 2 hours. After completion of this lamination step the resulting laminate is cooled to below 80°C under pressure, removed from the press, and trimmed to remove exuded resin. The resin content of laminated products produced from each of the two types of synthetic paper as above described is approximately 40% by weight.

A laminated board produced of lithium fluorhectorite paper as above described, when subjected to a 2-hour boiling water exposure to evaluate its moisture durability, can exhibit a water absorption as high as 1.7% by weight, with a loss tangent after treatment exceeding 0.3 (100 Hz) and a dielectric constant decreasing to below 2.9. In contrast, a laminated board product produced as described and comprising sodium fluormontmorillionoid crystals typically shows a boiling water absorption of 0.6% by weight, with an after-treatment dielectric constant of about 6.93 and a loss tangent of about 0.224.

In efforts to stabilize such electrical properties, variations on the process used to prepare laminated board products in accordance with Example I above have been under development to improve the moisture resistance and physical integrity thereof. For example, as described in the copending, commonly assigned application of E. R. Fretz et al., "Laminated Synthetic Mica Products", it has been found that synthetic mica papers can be treated with chemical coupling agents such as 6-aminocapoic acid and $\beta$-alanine to enhance coupling of the paper to the laminating resins used to consolidate the paper into boards. However, recent data indicate that, even utilizing such paper treatments, board products made with lithium-free papers according to the present invention exhibit better moisture resistance than board products prepared from comparably treated papers containing lithium fluorhectorite crystals.

Table I below reports experimental results obtained when sodium fluormontmorillionoid and lithium fluorhectorite papers are pretreated with $\beta$-alanine (ALA) or 6-aminocaproic acid (ACA) coupling agents prior to incorporation in laminated board products utilizing the procedure described in Example 1. Included in Table I for each of two compositions of laminated board and each of two paper pretreatments (ACA and ALA) are water absorption results, in weight percent of dry board weight after a 2-hour boiling treatment, as well as dielectric constant and loss tangent values for each product as measured at 100 Hz after the boiling water treatment.

## TABLE I

| Paper Type | Coupling Agent | $H_2O$ Weight Gain(%) | Dielectric Constant | Loss Tangent |
|---|---|---|---|---|
| Na fluoro-montmoril-lionoid | ACA | 0.22 | 5.3 | 0.031 |
| Li fluor-hectorite | ACA | 1.2 | 6.0 | 0.106 |
| Na fluoro-montmoril-lionoid | ALA | 0.44 | 5.36 · | 0.019 |
| Li fluor-hectorite | ALA | 0.96 | 5.87 | 0.099 |

The above data indicate the general superiority of the sodium fluormontmorillionoid-based laminated products in terms of electrical properties retention after exposure to a harsh moist environment when compared with lithium fluorhectorite-based products. The former products therefore constitute preferred materials for the preparation of laminated board products in accordance with the invention.

Whereas superior results are generally obtained using sodium fluoromontmorillionoid-based papers for board fabrication, alternative lithium free materials, particularly magnesium-based naturally occurring vermiculites, can be used as alternative crystal sources for the manufacture of durable electrical circuit board products. Example II below illustrates a procedure for making such products.

Example II

A vermiculite gel is prepared by dispersing a quantity of South African vermiculite in an aqueous 3M $\beta$-alanine solution to form a vermiculite gel comprising 10% vermiculite solids by weight. The vermiculite used first is screened to remove particle sizes above 270-mesh. The dispersed vermiculite forms a gel which is then centrifuged at 8000 rpm for 3 hours to separate the $\beta$-alanine-containing supernatant from the delaminated vermiculite particles. The liquid is decanted off and the vermiculite product is washed repeatedly in deionized water.

The delaminated washed vermiculite thus provided is slurried in a blender with distilled water to form a vermiculite suspension. A paper-making slurry is then prepared by adding the vermiculite suspension to an aqueous suspension of glass fibers in proportions providing four parts of vermiculite solids for each part of glass fibers, with a total solids content of about 9.7%. The pH of the slurry is maintained at about 2.5 by the addition of 10% aqueous sulphuric acid. The slurry is next flocculated by the addition of a small quantity of a 0.1% aqueous solution of a cationic flocculating agent, commercially available as Reten 210 flocculating agent, an acrylamide-based copolymer commercially available from Hercules, Inc. Wilmington, DE. The resulting floc is delivered to a hand sheet paper machine, drained, and finally dried to produce vermiculite paper sheet.

A laminated board product is prepared from this paper in accordance with the procedure described in Example I. The paper is first treated in a guanidine hydrochloride solution and dried. Thereafter it is impregnated with epoxy resin varnish and precured. Finally it is stacked to form a laminate and cured under heat and pressure to form a laminated board product approximately 26 mils in thickness with a resin content of 38.5% by weight.

The laminate produced from vermiculite as above described exhibits a dielectric constant of 4.28 and a loss tangent of 0.019 after exposure to water at ambient temperature for 24 hours. These properties indicate that the vermiculite laminate would exhibit better electrical properties than the lithium fluorhectorite product after a 2 hour boil test, but the properties would not be comparable to those of sodium fluormontmorillinoid-based products, due to relatively high water absorption shown by the vermiculite laminate.

While the use of lithium-free sheet silicate materials in the production of laminated board products can provide substantial improvements in electrical properties retention under moisture attack, further improvements in board properties, particularly in the physical integrity of the boards, are desired. For example, in laminated board products produced as described in Example I from sodium fluormontmorillionoid species, microscopic voids and cracks can be detected upon cross-sectional microscopic examination of the laminated board products, which voids and cracks are presently attributed at least partly to a failure of the laminating resin to completely impregnate the synthetic paper material.

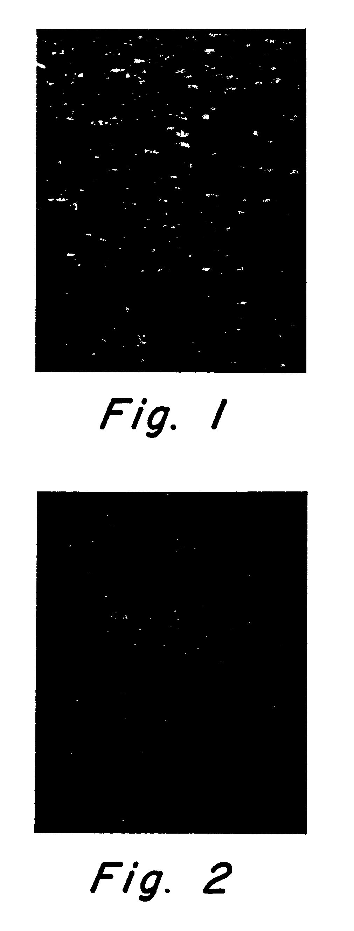

Fig. 1 of the drawing consists of an electron photomicrograph of a polished cross-section of an epoxy-resin-impregnated board product, produced utilizing the procedure of Example I, shown at a magnification of 200X. Microcracking in board products of this type occurs adjacent to and parallel with the sheet silicate crystals in the paper, which are aligned with the plane of the paper and appear as a pattern of light, wavy, vertical parallel lines in the micrograph. The pattern of small circular or oval light dots is formed by the sectioned ends of the glass fibers in the paper. A few relatively large cracking flaws in the board can also be observed, appearing at scattered locations in the micrograph as white-rimmed dark vertical cracks.

A further disadvantage attending the fabrication of board products utilizing the above-described procedures is the need to treat the paper in guanidine hydrochloride or other waterproofing organic solutions to enhance the moisture resistance thereof. Thus a process which would not require a separate paper treating step to enhance moisture resistance or resin/paper compatibility would be desirable.

In the prior art, attempts have been made to produce synthetic paper of enhanced moisture resistance through the use of special flocculating agents or other agents added during flocculation to impart hydrophobicity to the resulting paper. For example, U.S. Patent No. 4,454,237 describes the use of silane coupling agents as flocculation aids to produce paper exhibiting reduced moisture pickup under humid conditions, while U.S. Patent No. 4,455,382 describes the use of complex polyelectrolyte flocculation aids to achieve similar results.

We have now found that the use of an octylamine conditioning agent in combination with known flocculating agents such as described in the prior art can provide a paper exhibiting substantially improved lamination characteristics when used with epoxy or similar laminating resins to produce synthetic board products. Through the use of the octylamine additive, laminated board products substantially free of cracks and void defects are typically obtained without the need to treat the paper for hydration resistance prior to incorporation into the laminated product.

To compare the effects of flocculation treatments on the properties of laminated products, a series of epoxy-impregnated laminated boards were prepared from papers made from sodium fluormontmorillionoid gel as described in Example 1, but flocculated with additive solutions of a variety of different compositions. The procedures used and the properties of the resultant laminated board products are described in the following examples.

Examples 3-8

A standard procedure is utilized to prepare sodium fluormontmorillinoid papers by a handsheet method. Batches of paper-making slurry are prepared by first dispersing 0.7 grams of glass fibers (1/4-inch length) in 1300 ml of deionized water at a pH of 2.5, pH adjustment being by means of additions of 10% aqueous sulphuric acid. To prepare a papermaking gel from this suspension, 2.8 grams of sodium fluormontmorillinoid crystals (dry) are added to the fiber suspension with stirring.

One of a selected group of flocculating agent solutions is next added to the sodium fluormontmorillinoid gel to cause flocculation thereof, and each flocced suspension is then poured into a handsheet paper former, allowed to drain, dried by pressing between blotting paper, and then further dried at 80°C on a chrome-plated drier.

The flocculation agents used to prepare the various papers are selected from among the quaternary ammonium acid salts, primary and secondary amine complexes, and amino silanes. An aqueous solution of octylamine is also prepared for addition to the gels as a conditioner. Standard solutions of these additives are prepared for use in the study as shown in Table II below; four different types of gel additives are reported, with the active ingredient of each additive and the composition of each additive solution being noted.

## TABLE II

| Gel Additive Type | Active Compound | Solution Composition |
|---|---|---|
| quaternary ammonium salt | cetyltrimethyl-ammonium bromide (CTMA) | 10% aqueous CTMA |
| primary/secondary polyamine | polyethylene imine (PEI) | 0.2% aqueous Epomin SP-012 |
| aminosilane | N-β-aminoethyl--aminopropyl trimethoxy silane (Z6020 silane) | 2% aqueous Z6020, or 20% aqueous Z-6020 (pH 7.8) |
| octylamine | octylamine (OCA) | 10% aqueous octylamine.HCL (pH 8) |

Using the above agents, a series of 6 different paper types are prepared from sodium fluormontmorillionoid gels in accordance with the above-described procedure. As these papers are prepared, paper forming characteristics such as floc time, floc size, clarity of the supernatant white water from the handsheet former, wetness of the formed sheet, sheet wet strength, and final sheet weight were noted.

Table III below reports the results of paper forming for each of 6 different flocculating treatments employed using the gel additives described in Table II above. Included in Table III are an identification of the additive solution or solutions employed, the general sheet forming characteristics of each flocculated suspension, and the wet strength and sheet weight of the paper provided. In all cases, flocculation of the suspensions is essentially immediate, the floc sizes range from medium to large, and the white water generated during sheet formation ranges in clarity from cloudy to slightly cloudy or clear.

## TABLE III

| Example | Flocculant | Sheet Forming | Wet Strength | Sheet Weight |
|---------|-----------|---------------|--------------|--------------|
| 3 | 1.5 ml 10% CTMA | fair-good | good | 2.95 g |
| 4 | 10 ml 10% octylamine + 2.5 ml 0.2% PEI | good | fair | 2.9 g |
| 5 | 1 ml 20% Z6020 + 2.5 ml 0.2% PEI | fair-good | good | 3.0 g |
| 6 | 0.5 ml 2% Z6020 + 2.5 ml 10% CTMA | fair-good | good | 3.2 g |
| 7 | 25 ml 2% Z6020 | good | fair-good | 2.7 g |
| 8 | 1 ml 10% CTMA + 2.5 ml 0.2% PEI | good | good | 2.6 g |

To prepare board products from paper sheet produced as described, 6 × 6 inch sheets of each type of paper are epoxy-impregnated with the resin varnish described in Example 1, utilizing the impregnation and precuring procedures therein described. No pretreatment of these papers with guanidine hydrochloride or other agents is employed. During the precuring of the impregnated papers severe blistering of the papers of Example 3 in Table III above and some slight blistering of the Example 4 papers is noted. However no blistering of any of the papers occurs during the board lamination procedure.

To form laminated board products from the epoxy-impregnated papers thus provided, 13 sheets of each type of impregnated paper are stacked to form a laminate, and each of the 6 laminates is consolidated with heat and pressure utilizing the lamination procedure described in Example 1. The resulting laminated board products are then evaluated for electrical properties retention under moisture attack, and also for freedom from physical cracking and void defects by scanning electron microscope examination.

The results of the board evaluations for each of the 6 examples shown in Tables II and III above are reported in Table IV below. Included in Table IV for each of the boards produced as above described are the resin content of the board, in weight percent, the thickness of the board in mils, and the appearance of the board in magnified cross section under scanning electron microscope examination. The appearance of each board cross section was rated excellent (E), good (G), fair (F), or poor (P) for each of crack and void defects, excellent appearance corresponding to no observable cracking or voids and poor appearance corresponding to substantial cracking and/or many voids in the laminated product.

Also reported in Table IV for each laminate are the copper peel strength or force required to peel 0.25″ copper strip from the board after direct lamination to the board surface during the board lamination process, in pounds, the average water absorption exhibited by samples of each board after exposure to boiling water for 2 hours ($H_2O$ Uptake), and the electrical properties of the board samples after water treatment, including dielectric constant (D.C.), loss tangent (L.T.) and insulation resistance (I.R.) in ohms.

9

### TABLE IV

| Example No. | Flocculant | Resin Content | Thickness | SEM Cracks/ Voids | Copper Peel (lbs) |
|---|---|---|---|---|---|
| 3 | CTMA | 52.1% | 41 mils | E/G | 0.6 |
| 4 | octylamine /PEI | 52.2% | 45 mils | E/E | 1.2 |
| 5 | Z6020/PEI | 42% | 36 mils | P/P | 0.4 |
| 6 | Z6020/CTMA | 51.5% | 31 mils | E/G | 0.7 |
| 7 | Z6020 | 39% | 28 mils | F/P | 0.4 |
| 8 | CTMA/PEI | 51.2% | 43 mils | E/E | 0.4 |

### TABLE IV (concl.)

| Example No. | Flocculant | $H_2O$ Uptake | D.C. (100Hz) | L.T. (100Hz) | I.R. (Ohms) |
|---|---|---|---|---|---|
| 3 | CTMA | 0.19 | 5.38 | 0.320 | $3.9 \times 10^6$ |
| 4 | octylamine/ PEI | 0.18 | 5.04 | 0.050 | $1.4 \times 10^8$ |
| 5 | Z6020/PEI | 0.44 | 11.58 | 0.210 | $2.1 \times 10^5$ |
| 6 | Z6020/CTMA | 0.4 | 4.72 | 0.021 | $1.4 \times 10^8$ |
| 7 | Z6020 | 0.45 | 12.99 | 0.258 | $6.0 \times 10^6$ |
| 8 | CTMA/PEI | 0.27 | 5.88 | 0.049 | $5.6 \times 10^5$ |

Fig. 2 of the drawing consists of an electron photomicrograph at 200X magnification of a polished cross-section of an epoxy-resin-impregnated board product produced utilizing the flocculation procedure of Example 4 in Table IV above, wherein an octylamine conditioner is incorporated in the paper-making slurry at the flocculation stage. Such boards exhibit both reduced microcracking and improved cross-sectional homogeneity.

From the foregoing data, the use of octylamine as a conditioner with known flocculants, and particularly with polyelectrolyte amine compounds such as polyethylene imine, appears to offer the best combination of laminate integrity (freedom from crack and void-type defects) together with good retention of electrical properties after exposure to water attack. Thus the use of an octylamine conditioner during gel flocculation constitutes a particularly preferred expedient for the production of high-quality lithium-free laminated board products in accordance with the invention.

**Claims**

1. Method of making a laminated product comprising fused multiple sheets of inorganic paper impregnated with a laminating resin, by preparing a gel containing a water-swelling sheet silicate material, flocculating the gel to cause the silicate material to form a flocculated mass, forming the flocculated mass into inorganic paper sheets, impregnating the paper sheets with an organic laminating resin to form resin-impregnated sheets, stacking two or more of the resin-impregnated paper sheets into a laminate preform, and heating the preform under pressure at a temperature and for a time sufficient to obtain fusion of the sheets into an integral laminated product, <u>characterized</u> <u>in</u> <u>that</u> the sheet silicate is a lithium-free material comprising naturally occurring or synthetic silicate crystals.

2. Method in accordance with claim 1, characterized in that the lithium-free sheet silicate material comprises exchangeable interlayer cations selected from the group consisting of sodium, hydrogen, calcium and magnesium.

3. Method in accordance with claims 1 or 2, characterized in that the sheet silicate crystals are synthetic sodium montmorillionoid crystals.

4. Method in accordance with claims 1, 2 or 3, characterized in that the sheet silicate crystals are vermiculite crystals.

5. Method in accordance with any one of claims 1, 2, 3 or 4, characterized in that the step of flocculating the gel to cause the silicate material to form a flocculated mass comprises the addition of a flocculating agent together with an octylamine conditioning agent to the gel.

6. Method in accordance with any one of claims 1, 2, or 5 characterized in that the flocculation of the gel is induced by the addition of a polyethylene imine flocculation agent.

7. Method in accordance with any one of claims 1, 2, or 6 characterized in that the organic laminating resin comprises an epoxy resin.

8. A laminated product made in accordance with claim 5 characterized in that it exhibits, after a two-hour exposure to boiling water, a water absorption not exceeding 0.18% by weight, a dielectric constant of at least 5.04 at 100 cycles (Hz), and a loss tangent not exceeding 0.050 at 100 cycles (Hz).

Fig. 1

Fig. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,Y | EP-A-0 115 399 (CORNING GLASS WORKS) * Claims 1-3,6,7-10; page 8, line 10 - page 13, line 24 * | 1,7 | D 21 H 5/18 D 21 H 3/02 H 05 K 1/03 |
| Y | US-A-4 456 657 (R. CASSAT et al.) * Examples 2,3 * | 1 | |
| L | W.R. HAMILTON et al.: "Les Minéraux, Roches et Fossiles du Monde Entier en Couleurs", 1974, pages 122,123, Elsevier Séquoia, Brussels, BE * Page 122, paragraphs 1,2 * | 1 | |
| A | US-A-3 390 045 (J.L. MILLER, Jr. et al.) * Whole document * | 1 | |
| A | GB-A-2 172 883 (ARMSTRONG WORLD INDUSTRIES) * Page 1, line 45 - page 3, line 62 * | 1,2,4,6 ,7 | |
| A | DE-A-2 262 906 (SANDOZ) | | TECHNICAL FIELDS SEARCHED (Int. Cl.4) |
| A | US-A-3 184 373 (H.F. ARLEDTER) | | D 21 D D 21 H H 05 K |
| D,A | US-A-4 455 382 (S.-H. WU) | | |

The present search report has been drawn up for all claims

| Place of search | Date of completion of the search | Examiner |
|---|---|---|
| THE HAGUE | 25-11-1987 | NESTBY K. |

EPO FORM 1503 03.82 (P0401)